Europäisches Patentamt

European Patent Office

Office européen des brevets

(11) Veröffentlichungsnummer: **0 307 611 B1**

# (12) EUROPÄISCHE PATENTSCHRIFT

(45) Veröffentlichungstag der Patentschrift: **18.03.92**

(21) Anmeldenummer: **88112757.5**

(22) Anmeldetag: **05.08.88**

(51) Int. Cl.⁵: **C25D 5/02**, C25D 5/00

(54) Verfahren und Vorrichtung zur partiellen galvanischen Beschichtung.

(30) Priorität: **12.09.87 DE 3730740**

(43) Veröffentlichungstag der Anmeldung:
**22.03.89 Patentblatt 89/12**

(45) Bekanntmachung des Hinweises auf die
Patenterteilung:
**18.03.92 Patentblatt 92/12**

(84) Benannte Vertragsstaaten:
**BE DE FR GB IT LU NL**

(56) Entgegenhaltungen:
**DE-B- 2 510 092**
**US-A- 4 078 982**
**US-A- 4 452 684**

(73) Patentinhaber: **Degussa Aktiengesellschaft**
**Weissfrauenstrasse 9**
**W-6000 Frankturt am Main 1(DE)**

(72) Erfinder: **Kaiser, Hasso, Dipl.-Kaufm.**
**Hornbergstrasse 28**
**W-7070 Bettringen(DE)**
Erfinder: **Wingenfeld, Peter, Dipl.-Ing.**
**Degenfelderstrasse 86/2**
**W-7070 Weiler i.d.B.(DE)**
Erfinder: **Holdt, Dietmar, Dipl.-Ing.**
**Staufenstrasse 19**
**W-7078 Leinzell(DE)**
Erfinder: **Palnik, Karl**
**47 Richard Rd.**
**Ivyland, PA 18974(US)**

## Beschreibung

Die Erfindung betrifft ein Verfahren zur partiellen galvanischen Beschichtung von kontinuierlich an einer Anode vorbeiführbaren Gegenständen, insbesondere zur galvanischen Beschichtung von Kontaktkämmen und Kontaktstiften an ein- oder beidseitig bedruckten Leiterplatten, durch Inberührungbringen mit einem Elektrolyten über einen offenporigen, mit einer Anode in Verbindung stehenden, bewegten Elektrolytträger und eine Vorrichtung zur Durchführung dieses Verfahrens.

Gedruckte Schaltungen sind normalerweise mit Anschlußkämmen oder Kontaktstiften versehen, die sich längs an einer oder mehreren Seiten der Leiterplatte befinden. Diese Kontaktkämme bzw. -stifte müssen meist galvanisch beschichtet werden, um die elektrischen Eigenschaften, Härte oder Abriebfestigkeit an diesen für die Kontaktierung wichtigen Stellen zu verbessern.

Es sind hierfür Verfahren bekannt, bei denen die kathodisch geschalteten Gegenstände an anodisch geschalteten Sprühdüsen entlanggeführt und mit einem Elektrolyten angespritzt werden (z. B. DE-PS 34 23 033). Dabei müssen aber die zugeführten Elektrolyte unter einem hohen Druck auf die zu beschichtenden Teile der Gegenstände aufgebracht werden, um eine ausreichende Abscheidegeschwindigkeit zu gewährleisten. Der apparative Aufwand ist daher sehr hoch und Elektrolytverluste nur schwer vermeidbar.

Aus der US-PS 4 452 684 ist eine Vorrichtung bekannt, bei der die partiell zu beschichtenden Gegenstände an anodisch geschalteten rotierenden Rollen vorbeigeführt werden, die mit Belägen aus Geweben versehen sind und denen der Elektrolyt über die hohle Rollenachse zugeführt wird. Durch die offenen Poren des Gewebes dringt der Elektrolyt auf die Rollenoberfläche und kommt dadurch in Kontakt mit den zu beschichtenden Gegenständen. Nachteilig ist hierbei die unzureichende Begrenzung und Ungleichmäßigkeit der abgeschiedenen Schichten. In vielen Fällen ist zusätzlich ein Abkleben oder Abdecken der nicht zu beschichtenden Oberflächenteile notwendig.

Es war daher Aufgabe der vorliegenden Erfindung, ein Verfahren zur partiellen galvanischen Beschichtung von Gegenständen gemäß dem Oberbegriff von Patentanspruch 1 zu entwickeln, das eine gleichmäßige Schichtdickenverteilung und eine möglichst scharfe Schichtenbegrenzung ohne Verwendung einer zeitaufwendigen Abklebetechnik gewährleistet. Außerdem sollte eine möglichst hohe Abscheidegeschwindigkeit mit möglichst geringen Elektrolytvolumina erzielt werden. Dazu war eine Vorrichtung zur Durchführung dieses Verfahrens zu schaffen.

Diese Aufgabe wird erfindungsgemäß durch die Maßnahmen des kennzeichnenden Teils von Patentanspruch 1 gelöst. Dazu wird der Elektrolyt über eine ebene Fläche des Elektrolytträgers in Kontakt mit den zu beschichtenden Gegenständen gebracht und zusammen mit dem Elektrolytträger in mechanische Schwingungen in einer oder mehreren Ebenen versetzt.

Vorzugsweise beträgt die Frequenz dieser Schwingungen 10 Hz bis 50 kHz bei Amplituden von 1 bis 100 $\mu$m.

Mit Hilfe dieses Verfahrens, bei dem die mechanischen Schwingungen einen intensiven Rühr- und Abwischvorgang des Elektrolyten bewirken, erzielt man sehr hohe Abscheidungsgeschwindigkeiten bei der galvanischen Beschichtung. Trotz der Anwendung hoher Stromdichten kommt es zu keiner rauhen oder pulvrigen Abscheidung der Überzüge. Dabei kann der Elektrolytträger auf dem zu beschichtenden Gegenstand aufliegen oder einen kleinen, elektrolytgefüllten Spalt zu diesem ausbilden.

Das erfindungsgemäße Verfahren wird in einer Vorrichtung durchgeführt, die im wesentlichen aus einem Gehäuse besteht, in dem die zu beschichtenden Gegenstände mittels einer Transporteinrichtung an einem offenporigen Elektrolytträger vorbeigeführt werden, der in einer Halterung befestigt ist, an der auch die Elektrolytzuführung und die Anode angebracht ist, mit dem Kennzeichen, daß der Elektrolytträger wenigstens eine ebene Fläche aufweist und mit einem Vibrator verbunden ist, der mechanische Schwingungen in einer oder mehreren Ebenen auszuführen vermag.

Der Elektrolytträger besteht aus einem dem Elektrolyten gegenüber beständigen Material, wie Kunststoff-Filz, Glasgewebe, Glasfritte, Keramik oder Metallgewebe. Vorzugsweise verwendet man ein Kunststoff-Fasergewebe aus Polyäthylen, Polypropylen, Polyurethan oder Polyamid. Der Elektrolytträger besitzt vorteilhafterweise eine spezifische Porenoberfläche von 100 bis 5000 cm$^2$/cm$^3$.

Der Vibrator wird zweckmäßigerweise an der Elektrolytträgerhalterung angebracht und läßt sich auf Frequenzen von 10 Hz bis 50 kHz bei Amplituden von 1 bis 100 $\mu$m einstellen.

Außerdem hat es sich als günstig erwiesen, wenn wenigstens eine Fläche des Elektrolytträgers in ihrer Geometrie der Oberflächengeometrie des zu beschichtenden Gegenstandes angepaßt ist. Dabei ist es vorteilhaft, wenn der Elektrolytträger einen trapezförmigen Querschnitt aufweist und mindestens drei unterschiedlich breite, ebene Trapezflächen besitzt. Dadurch lassen sich verschiedene Beschichtungshöhen bzw. -breiten ohne große Umrüstungen schnell einstellen. Außerdem ist es günstig, wenn die ebenen Elektrolytträgerflächen in Abständen vertikale Einkerbungen aufweisen, um den Elektrolyten schneller abzuführen.

Von Vorteil ist es auch, wenn am Elektrolytträger oder an der Halterung Gummilippen angebracht sind, die für eine schärfere Abgrenzung zwischen den beschichteten und unbeschichteten Bereichen sorgen.

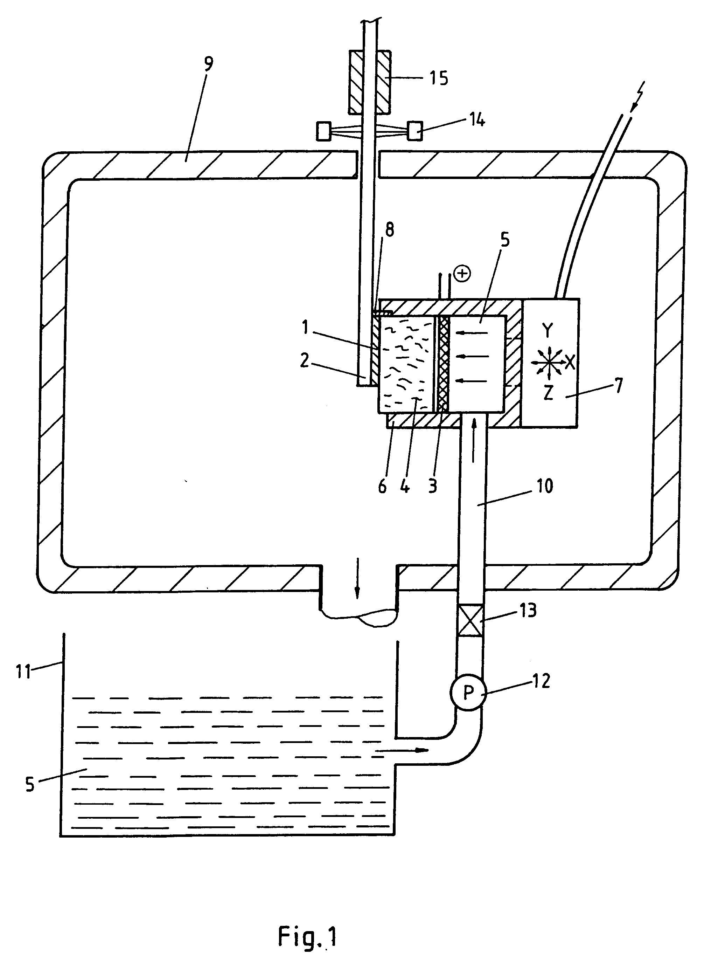

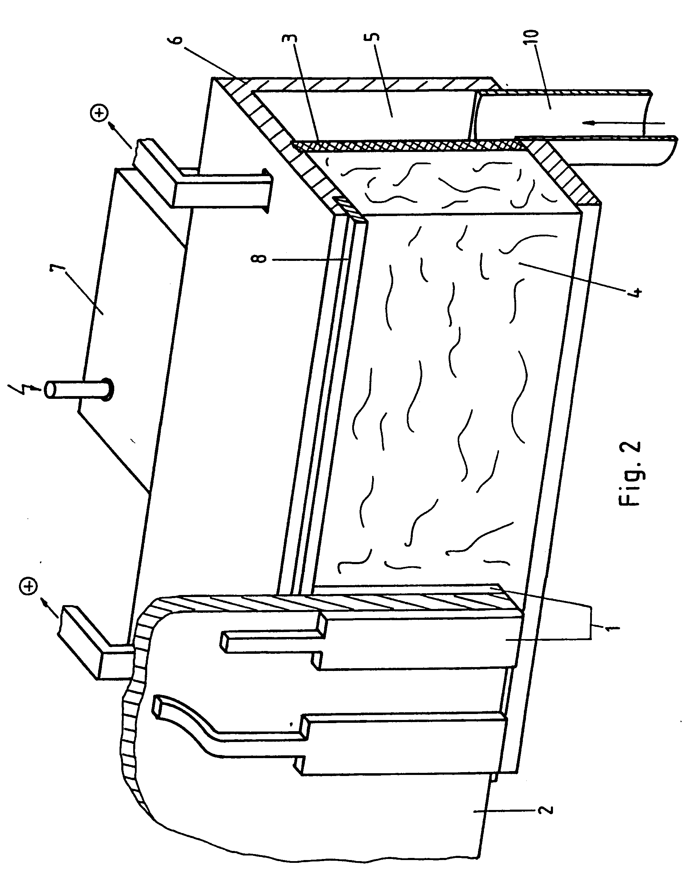

Das erfindungsgemäße Verfahren und die erfindungsgemäße Vorrichtung wird anhand der Abbildungen 1 bis 3 näher erläutert: Abbildung 1 zeigt einen Querschnitt durch die Vorrichtung, Abbildung 2 eine Ansicht des Elektrolytträgers von vorn und Abbildung 3 eine beispielhafte Ausgestaltung des Elektrolytträgers.

Die Vorrichtung besteht aus einem Gehäuse 9, das einen Spalt zum Einbringen der zu beschichtenden Gegenstände 2 aufweist, die mittels einer Transporteinrichtung 15 an dem Elektrolytträger 4 vorbeigeführt und mittels einer Kontaktiereinheit 14 kathodisch geschaltet werden. Am Elektrolytträger 4 wird auf den Gegenständen 2 partiell eine galvanische Schicht 1 aus einem Metall aufgebracht.

Der Elektrolytträger 4 befindet sich in einer Halterung 6, an die der Vibrator 7 angeflanscht ist. Außerdem ist an der Halterung 6, die einen Hohlraum bildet, die Elektrolytzuführung 10 und die Anode 3 angebracht. Der Vibrator 7 erzeugt mechanische Schwingungen, die auf die Halterung 6 und den Elektrolytträger 4 einwirken, der über ein Drosselsystem 13 und eine Pumpe 12 aus einem Vorratsbehälter 11 mit dem Elektrolyten 5 versorgt wird. Der aus dem Elektrolytträger austretende Elektrolyt fließt wieder in den Vorratsbehälter 11 zurück. Die mechanischen Schwingungen des Vibrators 7 bewirken im Elektrolyten 5 einen starken Rühreffekt und an der zu beschichtenden Gegenstandsoberfläche einen starken Wischeffekt. Der Elektrolyt 5 durchdringt den offenporigen Elektrolytträger 4 und wird gleichmäßig auf der Oberfläche verteilt. Zur scharfen Begrenzung der partiell aufgebrachten Metallschicht 1 ist an der Halterung 6 eine Gummilippe 8 befestigt.

Der Elektrolytträger 4 kann bei dem Galvanisiervorgang den zu beschichtenden Gegenstand 2 direkt berühren oder in einem entsprechenden Anstand gehalten werden, wobei der Spalt zwischen Elektrolytträger 4 und Gegenstand 2 mit einem Elektrolytfilm ausgefüllt sein muß.

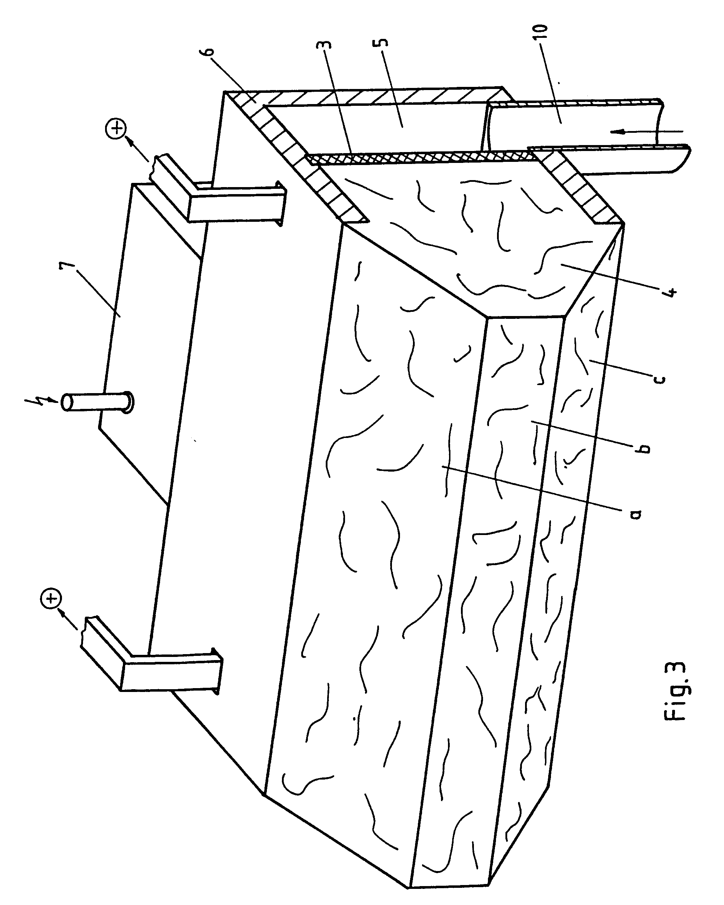

Gemäß Abbildung 3 kann der Elektrolytträger 4 einen trapezförmigen Querschnitt besitzen, so daß er drei verschieden breite Flächen a, b und c aufweist. Durch einfaches Drehen der Halterung 6 können die verschiedenen Elektrolytträgerflächen a, b und c den zu beschichtenden Gegenständen 2 ohne großen Aufwand optimal angepaßt werden.

Das erfindungsgemäße Verfahren besitzt beim partiellen Beschichten von Leiterplatten, Bändern oder anderen Gegenständen insbesondere folgende Vorteile:

a) Die Galvanisierung erfolgt durch einen gutdurchgemischten Elektrolyten, wodurch eine wesentlich höhere Stromdichte erreicht werden kann. Die Abscheidungsleistung nimmt gegenüber einem normalen Eintauchverfahren von ca. 2 $\mu$m/min auf 8-12 $\mu$m/min zu.

b) Durch die bessere Elektrolytverteilung mittels Vibration werden gleichmäßigere Schichten mit einer besseren Schichtdickenverteilung erzielt und damit der Metalleinsatz verringert.

c) Die eingesetzten Metallmengen und Voluminas können durch den besseren Elektrolytaustausch kleiner gehalten werden. Dies ergibt eine höherer Durchsatzleistung der Anlage aufgrund der höheren Geschwindigkeit.

## Patentansprüche

1. Verfahren zur partiellen galvanischen Beschichtung von kontinuierlich an einer Anode vorbeiführbaren Gegenständen, insbesondere zur galvanischen Beschichtung von Kontaktkämmen und Kontaktstiften an ein- oder beidseitig bedruckten Leiterplatten, durch Inberührungbringen mit einem Elektrolyten über einen offenporigen, mit einer Anode in Verbindung stehenden, bewegten Elektrolytträger, dadurch gekennzeichnet, daß der Elektrolyt über eine ebene Fläche des Elektrolytträgers in Kontakt mit dem zu beschichtenden Gegenständen gebracht wird und zusammen mit dem Elektrolytträger in mechanische Schwingungen versetzt wird.

2. Verfahren nach Anspruch 1, dadurch gekennzeichnet, daß die Frequenz der Schwingungen 10 Hz bis 50 kHz bei Amplituden von 1 bis 100 $\mu$m beträgt.

3. Vorrichtung zur partiellen galvanischen Beschichtung von Gegenständen nach Anspruch 1 und 2, bestehend aus einem Gehäuse, in dem die zu beschichtenden Gegenstände mittels einer Transporteinrichtung an einem offenporigen Elektrolytträger vorbeigeführt werden, der in einer Halterung mit einer Elektrolytzuführung und einer Anode angebracht ist, dadurch gekennzeichnet, daß der Elektrolytträger (4) wenigstens eine ebene Fläche aufweist und mit einem Vibrator (7) verbunden ist, der mechanische Schwingungen auszuführen vermag.

4. Vorrichtung nach Anspruch 3, dadurch gekennzeichnet, daß der Elektrolytträger (4) aus einem Kunststoff-Fasergewebe besteht und eine spezifische Porenoberfläche von 100 bis 5000

cm$^2$/cm$^3$ aufweist.

5. Vorrichtung nach Anspruch 3 und 4,
dadurch gekennzeichnet,
daß der Vibrator (7) an der Halterung (6) des
Elektrolytträgers (4) befestigt ist.

6. Vorrichtung nach den Ansprüchen 3 bis 5,
dadurch gekennzeichnet,
daß wenigstens eine Fläche des Elektrolytträgers (4) in ihrer Geometrie der Oberflächengeometrie des zu beschichtenden Gegenstands (2) angepaßt ist.

7. Vorrichtung nach den Ansprüchen 3 bis 6,
dadurch gekennzeichnet,
daß der Elektrolytträger (4) einen trapezförmigen Querschnitt aufweist und mindestens drei unterschiedlich breite, ebene Flächen aufweist.

8. Vorrichtung nach den Ansprüchen 3 bis 7,
dadurch gekennzeichnet,
daß die ebenen Flächen des Elektrolytträgers (4) vertikale Einkerbungen aufweisen.

9. Vorrichtung nach den Ansprüchen 3 bis 8,
dadurch gekennzeichnet,
daß am Elektrolytträger (4) oder an der Halterung (6) Gummilippen (8) angebracht sind.

## Claims

1. A process for the partial electroplating of articles movable continuously past an anode, in particular for the electroplating of contact combs and contact studs on circuit boards printed on one or both sides, by bringing the articles into contact with an electrolyte by way of an open-pored, moving electrolyte container in contact with an anode, characterised in that the electrolyte is brought into contact with the articles to be coated by way of a plane surface of the electrolyte container and is set into mechanical vibrations together with the electrolyte container.

2. Process according to claim 1, characterised in that the frequency of the vibrations is from 10 Hz to 50 kHz at amplitudes of from 1 to 100 $\mu$m.

3. A device for the partial electroplating of articles according to claims 1 and 2, consisting of a housing in which the articles to be coated are moved past an open pored electrolyte container by means of a conveyor device, which electrolyte container is mounted in a holder having an inlet for the supply of electrolyte and an anode, characterised in that the electrolyte container (4) has at least one plane surface and is connected with a vibrator (7) capable of executing mechanical vibrations.

4. Device according to claim 3, characterised in that the electrolyte container (4) consists of a plastics fibre fabric and has a specific pore surface of from 100 to 5000 cm$^2$/cm$^3$.

5. Device according to claims 3 and 4, characterised in that the vibrator (7) is fixed to the holder (6) of the electrolyte container (4).

6. Device according to claims 3 to 5, characterised in that at least one surface of the elctrolyte container (4) is adapted in its geometry to the surface geometry of the article (2) to be coated.

7. Device according to claims 3 to 6, charcterised in that the electrolyte carrier (4) is trapezoidal in cross-section and has at least three plane surfaces of differing widths.

8. Device according to claims 3 to 7, characterised in that the plane surfaces of the eletrolyte container (4) have vertical notches.

9. Device according to claims 3 to 8, characterised in that rubber lips (8) are attached to the electrolyte container (4) or to the holder (6).

## Revendications

1. Procédé pour le revêtement électrolytique partiel d'objets pouvant être passés en continu sur une anode, en particulier pour le revêtement électrolytique de peignes de contact et de pointes de contact sur des plaquettes à circuits imprimés d'un côté ou des deux, par mise en contact avec un électrolyte par l'intermédiaire d'un porteur d'électrolyte à pores ouverts, mis en mouvement, en connexion avec une anode, caractérisé en ce que l'électrolyte est mis en contact avec l'objet à revêtir par l'intermédiaire d'une face plane du porteur d'électrolyte et mis en vibrations mécaniques conjointement avec le porteur d'électrolyte.

2. Procédé selon la revendication 1, caractérisé en ce que la fréquence des vibrations va de 10 Hz à 50 kHz, avec des amplitudes de 1 à 100 $\mu$m.

3. Dispositif pour le revêtement électrolytique partiel d'objets selon la revendication 1 ou 2, constitué d'un boîtier dans lequel les objets à revêtir sont passés au moyen d'un dispositif de transport, sur un porteur d'électrolyte à pores ouverts qui est disposé dans un support comportant un conduit d'arrivée d'électrolyte et une anode, caractérisé en ce que le porteur (4) d'électrolyte présente au moins une face place et est relié à un vibrateur (7) qui permet d'effectuer des vibrations mécaniques.

4. Dispositif selon la revendication 3, caractérisé en ce que le porteur (4) d'électrolyte est constitué d'un tissu de fibres de matière plastique et présente une superficie spécifique de pores de 100 à 5000 $cm^2/cm^3$.

5. Dispositif selon la revendication 3 ou 4, caractérisé en ce que le vibrateur (7) est fixé sur le support (6) du porteur (4) d'électrolyte.

6. Dispositif selon l'une quelconque des revendications 3 à 5, caractérisé en ce qu'au moins une face du porteur (4) d'électrolyte est adaptée dans sa géométrie à la géométrie superficielle de l'objet (2) à revêtir.

7. Dispositif selon l'une quelconque des revendications 3 à 6, caractérisé en ce que le porteur (4) d'électrolyte présente une section transversale trapézoïdale et au moins trois faces planes de largeurs différentes.

8. Dispositif selon l'une quelconque des revendication 3 à 7, caractérisé en ce que les faces planes du porteur (4) d'électrolyte présentent des entailles verticales.

9. Dispositif selon l'une quelconque des revendications 3 à 8, caractérisé en ce que des lèvres de caoutchouc (8) sont disposées sur le porteur (4) d'électrolyte ou sur le support (6).

Fig.1

Fig. 2

Fig.3